# EUROPÄISCHE PATENTSCHRIFT

(11) **EP 1 908 129 B1**
(45) Veröffentlichungstag und Bekanntmachung des Hinweises auf die Patenterteilung: **26.12.2012**
(21) Anmeldenummer: 06762840.4
(22) Anmeldetag: 26.07.2006
(51) Int. Cl.: H01L 41/047, H01L 41/083

(54) **MONOLITHISCHER PIEZOAKTOR MIT ÄNDERUNG DER ELEKTRODENSTRUKTUR IM ÜBERGANGSBEREICH SOWIE VERWENDUNG DES PIEZOAKTORS**
MONOLITHIC PIEZO ACTUATOR WITH A CHANGE IN THE ELECTRODE STRUCTURE IN THE JUNCTION REGION, AND USE OF THE PIEZO ACTUATOR
ACTIONNEUR PIEZOELECTRIQUE MONOLITHIQUE A MODIFICATION DE LA STRUCTURE D'ELECTRODE DANS LA ZONE DE TRANSITION ET UTILISATION DUDIT ACTIONNEUR PIEZOELECTRIQUE

(30) Priorität: 26.07.2005 DE 102005034814
(43) Veröffentlichungstag der Anmeldung: 09.04.2008
(73) Patentinhaber: SIEMENS AKTIENGESELLSCHAFT, 80333 München (DE)
(72) Erfinder: KASTL, Harald, Johannes, 95686 Fichtelberg (DE); SCHUH, Carsten, 85598 Baldham (DE)
(86) Internationale Anmeldenummer: PCT/EP2006/007406
(87) Internationale Veröffentlichungsnummer: WO 2007/012485

(56) Entgegenhaltungen:
- DE-A1-102004 012 033
- JP-A- 7 030 165
- US-A- 5 266 862

## Beschreibung

Die Erfindung betrifft einen Piezoaktor in monolithischer Vielschichtbauweise, aufweisend mindestens einen piezoelektrisch aktiven Teilstapel, wobei der Teilstapel übereinander angeordnete Piezokeramikschichten mit piezokeramischem Werkstoff und zwischen den Piezokeramikschichten angeordnete Elektrodenschichten (Innenelektroden) aufweist, mindestens einen, über dem piezoelektrisch aktiven Teilstapel angeordneten piezoelektrisch inaktiven Abschlussbereich und mindestens einen zwischen dem piezoelektrisch aktiven Teilstapel und dem Abschlussbereich angeordneten Übergangsbereich, wobei der piezoelektrisch aktive Teilstapel, der Abschlussbereich und der Übergangsbereich zu einem monolithischen Gesamtstapel miteinander verbunden sind. Neben dem Piezoaktor wird eine Verwendung des Piezoaktors angegeben.

Die US 5 266 862 beschreibt ein Verfahren, mit welchem eine gleichförmige und glatte Verlängerung eines piezoelektrischen Aktors an den Stirnseiten erreichbar ist, wobei mindestens eine piezoelektrischen aktiven Schicht mit mindestens einem nicht-leitenden Bereich an dem zentralen Abschnitt ausgebildet ist und zwischen einer inaktiven Schicht und einer äußersten piezoelektrischen aktiven Schicht des Elements angeordnet ist.

Die JP 7 030 165 beschreibt eine piezoelektrische Vorrichtung mit einer Vielzahl von piezoelektrische Schichten, die dazu ausgebildet sind, mit internen und externen Elektroden angesteuert zu werden, wobei die internen Elektroden einen Überlappungsbereich auf den piezoelektrisch aktiven Schichten aufweisen.

Bei der erstmaligen elektrischen Ansteuerung solcher Piezoaktoren bis in den Großsignalbereich (Feldstärken von mehreren kV/mm) wird der piezokeramische Werkstoff gepolt. Dabei resultiert eine irreversible Längenänderung, die so genannte remanente Dehnung. Aufgrund der remanenten Dehnung und aufgrund einer zusätzlichen Dehnung, die bei elektrischer Ansteuerung der Elektrodenschichten im Betrieb des Piezoaktors auftritt, entstehen im Gesamtstapel Zugspannungen. Diese Zugspannungen führen dazu, dass im Verlauf der Polung oder im Betrieb des Piezoaktors beispielsweise entlang einer Grenzfläche zwischen einer Piezokeramikschicht und einer Elektrodenschicht Risse (Polungsrisse) entstehen. Solche Risse treten insbesondere auch im Übergangsbereich zwischen aktivem Teilstapel und Abschlussbereich auf. Besonders schädlich sind dabei sich verzweigende oder sich in Längsrichtung des Gesamtstapels ausbreitende Risse. Solche Risse führen unweigerlich zu vorzeitigem Ausfall des Piezoaktors.

Aufgabe der Erfindung ist es, einen Piezoaktor anzugeben, bei dem die Wahrscheinlichkeit für die Bildung der oben beschriebenen Risse und deren Wachstum im Vergleich zum Stand der Technik verringert ist.

Zur Lösung der Aufgabe wird ein Piezoaktor in monolithischer Vielschichtbauweise angegeben, aufweisend die Merkmale des Patentanspruchs 1.

Der Abschlussbereich kann ein Kopf- oder Fußbereich des Gesamtstapels sein. Der Abschlussbereich kann aus einer Schicht oder aus mehreren Schichten bestehen. Im letzteren Fall wird von einem Deckpaket gesprochen. Als Material des Abschlussbereichs kommen keramische oder metallische Materialien in Frage.

Ein piezokeramischer Werkstoff der Piezokeramikschichten und ein piezokeramischer Werkstoff der Übergangsbereichs-Piezokeramikschichten können gleich sein. Es können aber auch unterschiedliche Werkstoffe verwendet werden. Ebenso können die Schichtdicken dieser Schichten gleich oder unterschiedlich sein.

Die grundlegende Idee der Erfindung besteht darin, einen Übergangsbereich mit Gradierung der Struktur der Übergangsbereichs-Elektrodenschichten bereitzustellen. Durch die Gradierung ändert sich die piezoelektrisch aktive Fläche und damit das piezoelektrisch aktive Volumen von Piezokeramikschicht zu Piezokeramikschicht. Durch die Gradierung werden die aus dem Stand der Technik bekannten hohen Zugspannungen zwischen piezoelektrisch aktivem Teilstapel und piezoelektrisch inaktivem Abschlussbereich deutlich reduziert.

Durch die Änderung der Struktur wird eine Änderung der während des Polarisierens oder während des Betriebs auftretenden Dehnung bewirkt. Die resultierende Dehnung in der lateralen Richtung (a/b-Richtung) und die resultierende Dehnung in der Stapelrichtung (c-Richtung) setzen sich nicht mehr rein aus den d₃₁(negativ)- und d₃₃(positiv)-Anteilen zusammen. Es resultiert eine Überlagerung dieser Effekte. Bei bestimmten Richtungen eines Polungs- und Ansteuervektors zu den Schichtebenen wird eine minimale Dehnung in den jeweiligen Richtungen erreicht. Dies führt zu entsprechend geringen mechanischen Zugspannungen zwischen zwei Schichten des Übergangsbereichs.

Gemäß einer besonderen Ausgestaltung weist der aktive Teilstapel und/oder der Abschlussbereich eine aus dem Bereich von einschließlich 1 mm bis einschließlich 10 mm und insbesondere aus dem Bereich von einschließlich 3 mm bis einschließlich 5 mm ausgewählte Teilstapelhöhe aufweist. Beispielsweise beträgt die Teilstapelhöhe 2 mm. Es hat sich gezeigt, dass mit diesen Teilstapelhöhen Spannungsspitzen sehr gut abgebaut werden. Gemäß einer besonderen Ausgestaltung weist der Übergangsbereichs-Teilstapel eine aus dem Bereich von einschließlich 0,2 bis einschließlich 5,0 mm und insbesondere von einschließlich 0,5 bis einschließlich 2,0 mm ausgewählte Übergangsstapelhöhe auf. Mit den Teilstapeln sind sehr hohe Gesamtstapel zugänglich. In einer besonderen Ausgestaltung weist der Gesamtstapel eine Gesamtstapelhöhe auf, die aus dem Bereich von einschließlich 10 mm bis einschließlich 200 mm ausgewählt ist. Höhere Gesamtstapelhöhen sind ebenfalls zugänglich.

Dieser neue, zuverlässige Piezoaktor wird bevorzugt zur Ansteuerung eines Ventils und insbesondere eines Einspritzventils einer Brennkraftmaschine verwendet. Die Brennkraftmaschine ist beispielsweise ein Motor eines Kraftfahrzeugs.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.

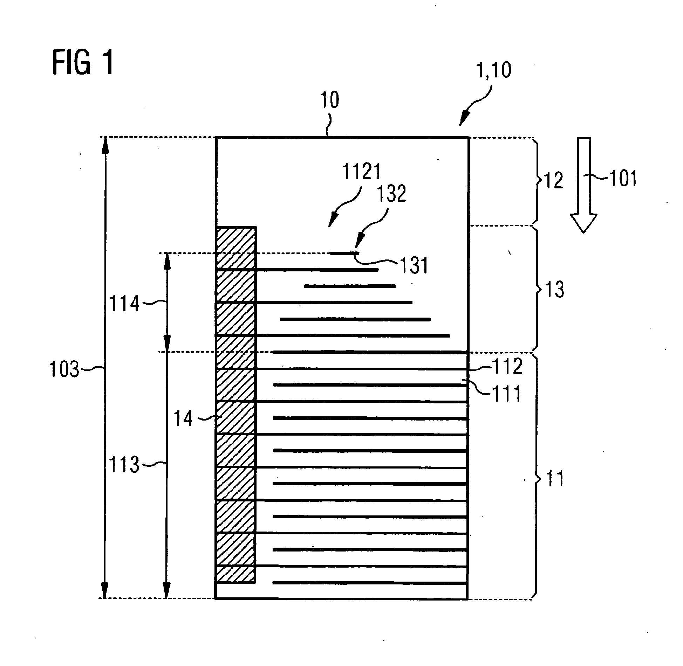

- Figur 1: zeigt einen Piezoaktor in monolithischer Vielschichtbauweise von der Seite.

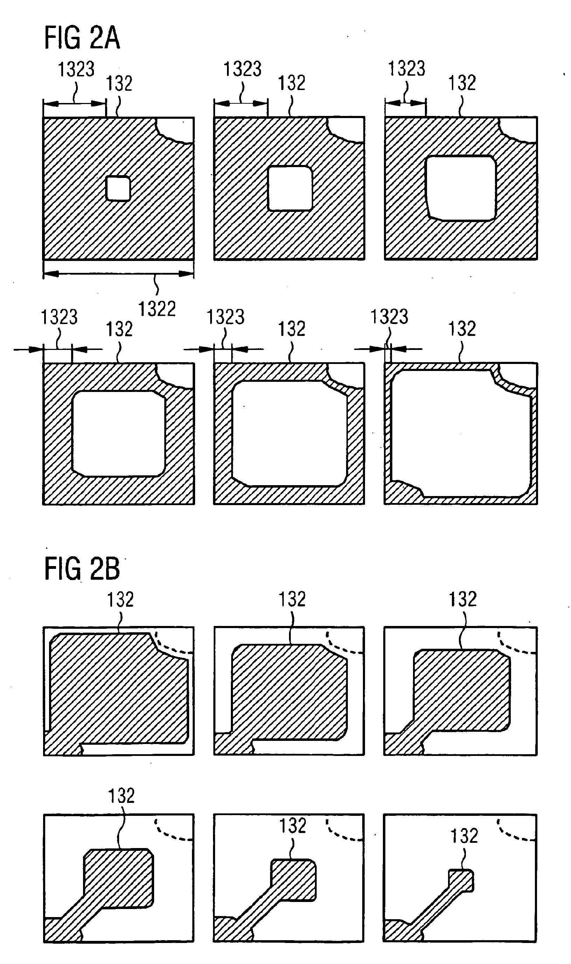

- Figur 2A: zeigt eine nicht erfindungsgemäße sukzessive Änderung der Struktur der Übergangsbereichs-Elektrodenschichten.
- Figur 2B: zeigt eine weitere nicht erfindungsgemäße sukzessive Änderung der Struktur der Übergangsbereichs-Elektrodenschichten
- Figur 3: zeigt eine sukzessive Änderung der kammartigen Struktur der Übergangsbereichs-Elektrodenschichten.

Der Piezoaktor 1 ist ein Piezoaktor mit einem Gesamtstapel 10 in monolithischer Vielschichtbauweise. Der Piezoaktor 1 weist einen piezoelektrisch aktiven Teilstapel 11 mit alternierend übereinander angeordneten Piezokeramikschichten 111 mit Bleizirkonattitanat (PZT) als piezokeramischem Werkstoff und Elektrodenschichten 112 aus einer Silber-Palladium-Legierung auf.

Über dem piezoelektrisch aktiven Teilstapel 11 ist ein piezoelektrisch inaktiver Abschlussbereich 12 in Form eines keramischen Deckpakets aus keramischen Schichten angeordnet.

Zwischen dem piezoelektrisch aktiven Teilstapel 11 und dem Deckpaket 12 ist ein Übergangsbereich 13 in Form eines Übergangsbereichs-Stapels angeordnet. Der Übergangsbereichs-Stapel 13 weist alternierend übereinander angeordnete Übergangsbereichs-Piezokeramikschichten 131 und Übergangsbereichs-Elektrodenschichten 132 auf. Der piezokeramische Werkstoff der Übergangsbereichs-Piezokeramikschichten und der piezokeramische Werkstoff der Piezokeramikschichten des piezoelektrisch aktiven Teilstapels 11 sind gleich. In einer alternativen Ausgestaltung sind die piezokeramischen Werkstoffe unterschiedlich. Das Elektrodenmaterial der Übergangsbereichs-Elektrodenschichten entspricht dem der Elektrodenschichten des piezoelektrisch aktiven Teil-Stapels. Alternativ werden unterschiedliche Elektrodenmaterialien verwendet.

Der piezoelektrisch aktive Teilstapel 11, der Übergangsbereichs-Stapel 13 und der Abschlussbereich 12 bilden zusammen einem monolithischen Gesamtstapel 10. An einer Seitenfläche des Gesamtstapels im Bereich des aktiven Teilstapels 11 und im Bereich des Übergangsbereichs-Stapels 13 ist eine Außenmetallisierung 14 zur elektrischen Kontaktierung der jeweiligen Elektrodenschichten angebracht. Zur alternierenden Kontaktierung ist eine weitere, nicht dargestellte Außenmetallisierung vorhanden.

Die Gesamthöhe 103 des Gesamtstapels 10 in Stapelrichtung 101 beträgt.30 mm. Die Teilstapelhöhe 113 piezoelektrisch aktiven Teilstapels 11 beträgt etwa 10 mm. Die Übergangsbereichs-Teilstapelhöhe 114 des Übergangsbereichs-Stapels 13 beträgt etwa 2 mm.

Die Übergangsbereichs-Piezokeramikschichten 131 und die Übergangsbereichs-Elektrodenschichten 132 sind derart ausgestaltet und aneinander angeordnet, dass in Stapelrichtung 133 des Übergangsbereichs-Stapels 13 von Übergangsbereichs-Piezokeramikschicht zu Übergangsbereichs-Piezokeramikschicht sukzessive eine piezoelektrisch aktive Fläche pro Übergangs-Piezokeramikschicht geändert wird. Dies wird durch Änderung der lateralen Abmessung 1323 der Übergangsbereichs-Elektrodenschichten erreicht. Entlang der lateralen Ausdehnung 1322 der Übergangsbereichs-Elektrodenschichten ändert sich die Abmessung 1323.

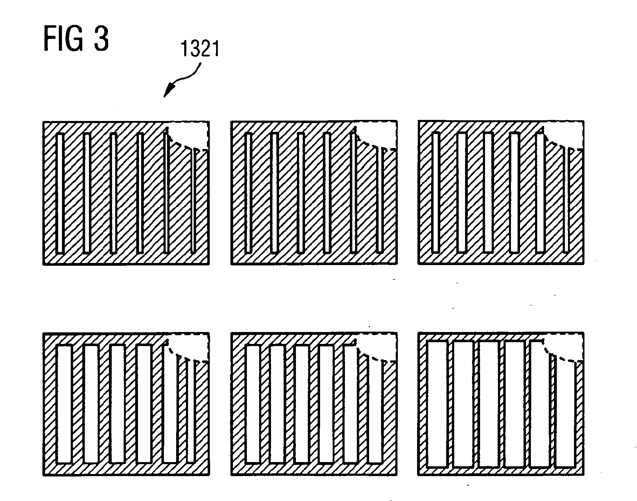

Die Übergangsbereichs-Elektrodenschichten 132 weisen eine kammartige Struktur auf. Diese kammartige Struktur 1321 ist in Figur 3 angedeutet.

Dem gemäß wird die kammartige Struktur 1321 der Übergangsbereichs-Elektrodenschichten 132 sukzessive geändert. Wie in Figur 3 angedeutet, wird ein Abstand zwischen Stegen der kammartigen Struktur 1321 von Übergangsbereichs-Elektrodenschicht zu Übergangsbereichs-Elektrodenschicht verändert. Benachbarte Übergangsbereichs-Elektrodenschichten 132 bilden zusammen jeweils eine Interdigital-Struktur 1121.

Weitere Ausführungsbeispiele ergeben sich dadurch, dass nicht nur bzw. alternativ zur dargestellten Anordnung des Abschlussbereichs 12 und des Übergangsbereichs 13 im Kopfbereich des Gesamtstapels 10 der Abschlussbereich 12 und der Übergangsbereich im Fußbereich des Gesamtstapels 10 angeordnet wird.

Dieser neue Piezoaktor 1 wird zur Ansteuerung eines Einspritzventils eines Motors eines Kraftfahrzeugs verwendet.

## Patentansprüche

1. Piezoaktor (1) in monolithischer Vielschichtbauweise, aufweisend
- mindestens einen piezoelektrisch aktiven Stapel (11), wobei der Stapel übereinander angeordnete Piezokeramikschichten (111, 121) und zwischen den Piezokeramikschichten angeordnete Elektrodenschichten (112, 122) aufweist,
- mindestens einen, über dem piezoelektrisch aktiven Stapel angeordneten piezoelektrisch inaktiven Abschlussbereich (12) und
- mindestens einen zwischen dem piezoelektrisch aktiven Stapel und dem Abschlussbereich angeordneten Übergangsbereich, (13) wobei
- der piezoelektrisch aktive Stapel, der Abschlussbereich und der Übergangsbereich zu einem monolithischen Gesamtstapel (10) miteinander verbunden sind,
- der Übergangsbereich übereinander angeordnete Übergangsbereichs-Piezokeramikschichten (131) und zwischen den Übergangsbereichs-Piezokeramikschichten angeordnete Übergangsbereichs-Elektrodenschichten (132) aufweist und
- die Übergangsbereichs-Piezokeramikschichten und die Übergangsbereichs-Elektrodenschichten derart ausgestaltet und aneinander angeordnet sind, dass in Stapelrichtung des Übergangsbereichs von Übergangsbereichs-Piezokeramikschicht zu Übergangsbereichs-Piezokeramikschicht sukzessive eine piezoelektrisch aktive Fläche pro Übergangs-Piezokeramikschicht geändert ist,
**dadurch gekennzeichnet, dass**
- eine Struktur der jeweiligen Übergangsbereichs-Elektrodenschicht parallel zu ihrer lateralen Ausdehnung (1322) Kammartig ist.

2. Piezoaktor nach Anspruch 1, wobei benachbarte Übergangsbereichs-Elektrodenschichten eine Interdigital-Struktur (1121) bilden.

3. Piezoaktor nach Anspruch 1 oder 2, wobei der aktive Teilstapel und/oder der Abschlussbereich eine aus dem Bereich von einschließlich 1 mm bis einschließlich 10 mm und insbesondere eine aus dem Bereich von einschließlich 3 mm bis einschließlich 5 mm ausgewählte Teilstapelhöhe (113) aufweist.

4. Piezoaktor nach einem der Ansprüche 1 bis 3, wobei der Übergangsbereich-Teilstapel eine aus dem Bereich von einschließlich 0,2 bis einschließlich 5,0 mm und insbesondere von einschließlich 0,5 bis einschließlich 2,0 mm ausgewählte Übergangsstapelhöhe (114) aufweist.

5. Piezoaktor nach einem der Ansprüche 1 bis 4, wobei der Gesamtstapel eine Gesamtstapelhöhe (103) aufweist, die aus dem Bereich von einschließlich 10 mm bis einschließlich 200 mm ausgewählt ist.

6. Verwendung eines Piezoaktors nach einem der Ansprüche 1 bis 5 zur Ansteuerung eines Ventils und insbesondere eines Einspritzventils einer Brennkraftmaschine.

## Claims

1. Piezo actuator (1) in a monolithic multilayered design, having
- at least one piezoelectrically active stack (11), where the stack comprises stacked piezoceramic layers (111, 121) and electrode layers (112, 122) arranged between the piezoceramic layers,
- at least one piezoelectrically inactive terminating region (12) arranged above the piezoelectrically active stack, and
- at least one transition region (13) arranged between the piezoelectrically active stack and the terminating region, where
- the piezoelectrically active stack, the terminating region and the transition region are joined together to form a monolithic total stack (10),
- the transition region comprises stacked transition-region piezoceramic layers (131) and transition-region electrode layers (132) arranged between the transition-region piezoceramic layers, and
- the transition-region piezoceramic layers and the transition-region electrode layers are in a form and are arranged on one another such that from transition-region piezoceramic layer to transition-region piezoceramic layer in the stack direction of the transition region, one piezoelectrically active area per transition piezoceramic layer is successively changed,
**characterised in that**
- a structure of the respective transition-region electrode layer parallel to its lateral dimension (1322) is formed like a comb.

2. Piezo actuator according to claim 1, wherein adjacent transition-region electrode layers form an interdigital structure (1121).

3. Piezo actuator according to claim 1 or 2, wherein the active sub-stack and/or the terminating region has a sub-stack height (113) selected from the range 1 mm to 10 mm inclusive, and in particular one from the range 3 mm to 5 mm inclusive.

4. Piezo actuator according to any of claims 1 to 3, wherein the transition region sub-stack has a transition-stack height (114) selected from the range 0.2 mm to 5.0 mm inclusive, and in particular from 0.5 mm to 2.0 mm inclusive.

5. Piezo actuator according to any of claims 1 to 4, wherein the total stack has a total-stack height (103) that is selected from the range 10 mm to 200 mm inclusive.

6. Use of a piezo actuator according to any of claims 1 to 5 for operating a valve, and in particular an injection valve of an internal combustion engine.

## Revendications

1. Piézoactionneur (1) de construction multicouche monolithique, comprenant
- au moins un empilement (11) piézoélectriquement actif, ledit empilement étant constitué de couches piézocéramiques (111, 121) superposées et de couches d'électrodes (112, 122) intercalées entre les couches piézocéramiques,
- au moins une zone terminale (12) piézoélectriquement inactive, disposée au-dessus de l'empilement piézoélectriquement actif, et
- au moins une zone de transition (13), disposée entre l'empilement piézoélectriquement actif et la zone terminale, dans lequel
- l'empilement piézoélectriquement actif, la zone terminale et la zone de transition sont reliés entre eux pour former un empilement entier (10) monolithique,
- la zone de transition est constituée de couches piézocéramiques (131) superposées et de couches d'électrodes (132) intercalées entre les couches piézocéramiques, et
- les couches piézocéramiques de la zone de transition et les couches d'électrodes de la zone de transition sont disposées l'une contre l'autre et réalisées de telle sorte que dans le sens d'empilement de la zone de transition, de couche piézocéramique en couche piézocéramique de celle-ci, une face piézoélectriquement active par couche piézocéramique de transition est successivement modifiée,
**caractérisé en ce que**
une structure de la couche d'électrode respective de la zone de transition, parallèlement à son extension latérale (1322), est en forme de peigne.

2. Piézoactionneur selon la revendication 1, dans lequel les couches d'électrodes voisines de la zone de transition forment une structure interdigitale (1121).

3. Piézoactionneur selon la revendication 1 ou la revendication 2, dans lequel l'empilement partiel actif et/ou la zone terminale présente une hauteur d'empilement partiel (113) sélectionnée dans la plage comprise entre 1 mm et 10 mm et en particulier dans la plage comprise entre 3 mm et 5 mm.

4. Piézoactionneur selon l'une des revendications 1 à 3, dans lequel l'empilement partiel de la zone de transition présente une hauteur d'empilement de transition (114) sélectionnée dans la plage comprise entre 0,2 et 5,0 mm et en particulier entre 0,5 et 2,0 mm.

5. Piézoactionneur selon l'une des revendications 1 à 4, dans lequel l'empilement entier présente une hauteur d'empilement entier (103) sélectionnée dans la plage comprise entre 10 mm et 200 mm.

6. Utilisation d'un piézoactionneur selon l'une des revendications 1 à 5 pour la commande d'une soupape et en particulier d'une soupape d'injection d'un moteur à combustion interne.
